# EUROPEAN PATENT APPLICATION

(11) **EP 4 429 049 A1**
(43) Date of publication of application: **11.09.2024**
(21) Application number: 21965935.6
(22) Date of filing: 30.11.2021
(51) Int. Cl.: H01S 5/024, H01S 3/042

(54) **LIGHT SOURCE MODULE, DETECTION DEVICE AND TERMINAL DEVICE**

(71) Applicant: Huawei Technologies Co., Ltd., Shenzhen, Guangdong 518129 (CN)
(72) Inventor: LIU, Jun, Shenzhen, Guangdong 518129 (CN); YU, Anliang, Shenzhen, Guangdong 518129 (CN); GAO, Lei, Shenzhen, Guangdong 518129 (CN); ZHAO, Bo, Shenzhen, Guangdong 518129 (CN); ZHU, Dingjun, Shenzhen, Guangdong 518129 (CN); WANG, Wei, Shenzhen, Guangdong 518129 (CN)
(74) Representative: Isarpatent
(86) International application number: PCT/CN2021/134576
(87) International publication number: WO 2023/097497

(57) **Abstract**

This application discloses a light source module, a detection device, and a terminal device, to resolve a problem that a center wavelength of a transmitted optical signal shifts due to temperature instability of a light source in the light source module in the conventional technology. The light source module and the devices can be applied to the field such as autonomous driving, intelligent driving, or optical display. The light source module includes a light source component configured to transmit an optical signal, a cooling component stacked with the light source component, and a storage structure, where the storage structure includes at least one first side wall, and the at least one first side wall contains at least a part of the cooling component. Heat of the light source component may be cooled by using the cooling component, and heat conduction to the light source component may be further weakened or blocked (in other words, stopped) by using the storage component. Therefore, the light source component can stay in a stable temperature range, and the light source component can further maintain a stable center wavelength and a stable emitting power.

## Description

### TECHNICAL FIELD

This application relates to the field of sensor technologies, and in particular, to a light source module, a detection device, and a terminal device.

### BACKGROUND

With the development of laser technologies, devices using the laser technologies are increasingly widely used, for example, a lidar device, a head-up device (head-up device, HUD), and the like. The devices using the laser technologies include a laser light source. A center wavelength of the laser light source shifts as a temperature changes. The center wavelength is a wavelength corresponding to a center position of a full width at half maximum (full width at half maxima, FWHM) of a spectrum obtained through measurement by the laser light source at a specific temperature and a rated power. The full width at half maximum may also be referred to as a full width half maximum, a half width, a half-peak width, a half-height width, or the like, and is a peak width at half-height of a spectral peak value, that is, a corresponding wavelength difference obtained when intensities on both sides of the spectral peak value decrease to half of the peak value. In a scenario, a temperature of the laser light source increases over time during operation. When the temperature of the laser light source increases, a center wavelength of an optical signal transmitted by the laser light source moves in a long wavelength direction. When the temperature of the laser light source decreases, the center wavelength of the optical signal transmitted by the laser light source moves in a short wavelength direction. In addition, an emitting power that is output by the laser light source decreases as the temperature increases. Therefore, to obtain a stable center wavelength and emitting power, it is important to improve stability of the temperature of the laser light source during a packaging process of the laser light source. Especially when the laser light source is applied to a scenario with frequent temperature changes, there is a higher requirement on temperature stability and reliability of the laser light source.

Therefore, how to improve the stability of the temperature of the laser light source is a technical problem to be resolved urgently.

### SUMMARY

This application provides a light source module, a detection device, and a terminal device, to improve stability of a temperature of a light source component in the light source module.

According to a first aspect, this application provides a light source module. The light source module includes a light source component, a cooling component, and a storage structure. The storage structure includes at least one first side wall, and the at least one first side wall contains at least a part of the cooling component. The cooling component is stacked with the light source component.

It should be noted that the light source module may also be referred to as an optical module, a laser transmitting module, or the like.

Based on the light source module, heat of the light source component may be cooled by using the cooling component, and heat conduction to the light source component may be further weakened or blocked (in other words, stopped) by using the storage component. Therefore, the light source component can stay in a stable temperature range, and the light source component can further maintain a stable center wavelength and a stable emitting power.

Specifically, in an operation process of a device in which the light source module is located, the light source component is configured to transmit an optical signal, and the cooling component is configured to conduct heat of the light source component. Heat of the light source component may include but is not limited to heat generated by operation of the light source component, and/or heat of an environment in which the light source component is located, and/or heat generated by a structure around the light source component. The first side wall is configured to weaken or block heat conducted to the light source component. The heat conducted to the light source component includes at least a part of returning heat of the light source component.

In a possible implementation, the storage structure further includes a bottom plate, and the bottom plate is in contact with a first end of the first side wall. Further, optionally, the bottom plate and the first side wall may be in direct contact or may be in indirect contact.

The first side wall may be supported by the bottom plate. The bottom plate and the first side wall may together form a structure that surrounds at least a part of the cooling component.

In a possible implementation, a thermal conductivity of a material of the bottom plate is higher than a thermal conductivity of a material of the first side wall.

The first side wall formed by a material of a low thermal conductivity can effectively weaken or block heat conduction to the light source component. Further, the bottom plate formed by using a material of a high thermal conductivity helps further conduct heat of the light source component outward from the light source component, that is, helps improve heat dissipation effect on the light source component.

Specifically, the thermal conductivity of the material of the first side wall is smaller than a second threshold, where the second threshold is related to a cooling range of the cooling component and heat returned by the first side wall. It may also be understood that the thermal conductivity of the material of the first side wall can reduce the heat conducted to the light source component as much as possible. Even if a small amount of heat is conducted to the light source component, effective temperature control can be implemented by re-cooling of the cooling component. Therefore, the light source component is in a stable temperature range.

Further, optionally, the material of the first side wall may be a heat insulation material, and/or the material of the bottom plate may be a heat conduction material.

The first side wall is formed by using the heat insulation material, which can effectively block or weaken the heat conducted to the light source component. The heat of the light source component can be effectively dissipated through the bottom plate formed by the heat conduction material.

For example, the material of the first side wall includes any one or a combination of two of the following: glass or acrylic. The material of the bottom plate may include, but is not limited to, Kovar alloy, tungsten copper alloy, invar, copper, and the like.

In a possible implementation, the first side wall is of a "strip" type, an "L" type (including an "L-like" type), or the like. It may be understood that, when the first side wall is of the "strip" type, a structure of the first side wall is simple to manufacture, and therefore packaging of the light source module is simplified.

The following describes two example manners of connection between the second end of the first side wall and the light source component.

Manner 1: The second end of the first side wall is connected to the light source component by using the structural adhesive, and the second end of the first side wall is opposite to the first end of the first side wall.

The first side wall and the light source component are connected by using the structural adhesive. This helps improve strength of the light source module, and can further increase heat that is of the light source component and that is transmitted to the outside of the light source component.

Manner 2: The second end of the first side wall is also connected to the light source component through welding.

By welding the second end of the first side wall and the light source component, the strength of the light source module is improved.

In a possible implementation, the storage structure further includes at least one second side wall, and the at least one second side wall includes at least a part of the first side wall. Further, optionally, the at least one second side wall may further contain at least a part of the light source component.

The second side wall helps further reduce heat conduction to the light source component. In addition, the second side wall may be used to surround at least a part of the first side wall, and may further surround at least a part of the light source component.

Further, optionally, the second side wall may be higher than the light source component, or may be of a same height as the light source component. In this way, the second side wall can also contain the light source component.

In a possible implementation, the bottom plate and the second side wall are integrally formed.

Based on this, a structure obtained through integration of the bottom plate and the second side wall may be referred to as a package housing. The first side wall, the cooling component, and the light source component may be packaged in the package housing.

In a possible implementation, the second side wall is higher than the first side wall.

When the second side wall is set to be higher than the first side wall, the second side wall can contain the first side wall as much as possible. When the light source module further includes a shielding cover, the second side wall helps prevent the shielding cover from contacting the light source component.

Further, optionally, the shielding cover is electrically connected to the bottom plate or the second side wall. In this way, electromagnetic radiation can be shielded for the light source module.

In a possible implementation, a thermally conductive adhesive is filled between the bottom plate and a support component, and the support component is configured to support the light source module; and/or a thermally conductive adhesive is filled between the bottom plate and the cooling component.

The thermally conductive adhesive is filled between the bottom plate and the support component and/or between the bottom plate and the cooling component. This helps further improve the heat dissipation effect of the light source component.

It should be noted that the support component may be a component dedicated to supporting the light source module and dissipating the heat of the light source module, for example, may be a thermally conductive support or a heat sink. Alternatively, the support component may be another structure that is around the light source module and that can support the light source module and dissipate the heat of the light source module.

In still another possible implementation, the bottom plate includes an opening. The cooling component passes through the opening and is in contact with the support component. Further, the cooling component may be in direct contact or indirect contact with the support component. For example, the thermally conductive adhesive is filled between the cooling component and the support component.

The cooling component is in contact with the support component, and therefore, the cooling component can directly conduct the heat of the light source component outward. In this way, a heat dissipation path is shorter, and the heat of the light source component can be effectively conducted outward from the light source component.

Further, optionally, a structural adhesive is filled between a non-opening area of the bottom plate and the support component.

The strength of the light source module is improved by filling the structural adhesive between the non-opening area of the bottom plate and the support component.

In a possible implementation, the light source component includes a light source and a substrate; and the substrate drives the light source to transmit the optical signal.

In a possible implementation, a difference between any two of a coefficient of thermal expansion of the substrate, a coefficient of thermal expansion of the second side wall, and a coefficient of thermal expansion of the first side wall is less than a first threshold. Herein, the difference is limited to be less than the first threshold, so that the three coefficients of thermal expansion are adapted. For example, the first threshold may be 10 parts per million (parts per million, ppm), where 1 ppm is one in a million.

In this way, it can be ensured that the coefficients of thermal expansion of the first side wall, the second side wall, and the substrate are adapted. This helps to avoid problems, such as fracture or warpage, that occur at different temperatures and that are caused by the difference between the coefficients of thermal expansion of the first side wall, the substrate, and the second side wall.

In a possible implementation, the light source includes a laser diode. The laser diode has advantages of high efficiency, small size, long life cycle, and the like.

According to a second aspect, this application provides a detection device. The detection device includes the light source module in any one of the first aspect or the implementations of the first aspect.

In a possible implementation, the detection device may further include a receiving module, configured to receive an echo signal corresponding to an optical signal, where the echo signal is used to obtain association information of a target detected by the detection device.

For example, the detection device may be a lidar device. Further, optionally, the association information of the target may include but is not limited to distance information of the target, a direction of the target, a speed of the target, and/or grayscale information of the target.

In another possible implementation, the detection device may further include an image obtaining module configured to obtain image information.

For example, the detection device may be a fusion sensor. The fusion sensor is a sensor integrating functions of the lidar device and a camera.

According to a third aspect, this application provides a terminal device. The terminal device includes the detection device in any one of the second aspect or the implementations of the second aspect.

Further, optionally, the terminal device may further include a processor configured to plan a driving route based on association information and/or image information of a target.

In a possible implementation, the terminal device may include but is not limited to a vehicle (for example, an unmanned vehicle, an intelligent vehicle, an electric vehicle, or a digital vehicle), a robot, a surveying and mapping device, an unmanned aerial vehicle, a smart home device (for example, a robot vacuum), a smart manufacturing device (for example, an industrial device), a smart transport device (for example, an automated guided vehicle (automated guided vehicle, AGV), an unmanned transport vehicle, or a truck), or the like.

According to a fourth aspect, this application provides an optical display device. The optical display device includes the light source module in any one of the first aspect or the implementations of the first aspect.

For example, the optical display device may include but is not limited to an in-vehicle display, a head-up device (head-up device, HUD), a near eye display (near eye display, NED) device, a projector, and a smart home device (for example, a smart desk lamp, a sound system, a smart lighting system, an electrical appliance control system, home background music, a home theater system, an intercom system, or video surveillance).

### BRIEF DESCRIPTION OF DRAWINGS

FIG. 1a is a schematic diagram of a possible application scenario according to this application;
FIG. 1b is a schematic diagram of another possible application scenario according to this application;
FIG. 1c is a schematic diagram of still another possible application scenario according to this application;
FIG. 1d is a schematic diagram of yet another possible application scenario according to this application;
FIG. 1e is a schematic diagram of still yet another possible application scenario according to this application;
FIG. 1f is a schematic diagram of a further possible application scenario according to this application;
FIG. 2 is a schematic diagram of a structure of a light source module according to this application;
FIG. 3 is a schematic diagram of a cooling principle of a TEC according to this application;
FIG. 4a is a schematic diagram of a structure of a storage structure according to this application;
FIG. 4b is a schematic diagram of a structure of another storage structure according to this application;
FIG. 4c is a schematic diagram of a structure of still another storage structure according to this application;
FIG. 4d is a schematic diagram of a structure of yet another storage structure according to this application;
FIG. 4e is a schematic diagram of a structure of still yet another storage structure according to this application;
FIG. 4f is a schematic diagram of a structure of a further storage structure according to this application;
FIG. 4g is a schematic diagram of a structure of a still further storage structure according to this application;
FIG. 5a is a schematic diagram of a position relationship between first side walls and a bottom plate according to this application;
FIG. 5b is a schematic diagram of a position relationship between first side walls, a light resource module, and a bottom plate according to this application;
FIG. 5c is a schematic diagram of another position relationship between first side walls, a light resource module, and a bottom plate according to this application;
FIG. 6a is a schematic diagram of a position relationship between a bottom plate and a cooling component according to this application;
FIG. 6b is a schematic diagram of still another position relationship between a bottom plate and a cooling component according to this application;
FIG. 7a is a schematic diagram of a structure of a yet further storage structure according to this application;
FIG. 7b is a schematic diagram of a structure of a still yet further storage structure according to this application;
FIG. 8 is a schematic diagram of a structure of a shielding cover and a storage structure according to this application;
FIG. 9 is a schematic diagram of a structure of another light source module according to this application;
FIG. 10 is a schematic diagram of a structure of still another light source module according to this application;
FIG. 11 is a schematic diagram of a structure of a lidar device according to an embodiment of this application; and
FIG. 12 is an example function block diagram of a vehicle according to this application.

### DESCRIPTION OF EMBODIMENTS

The following describes in detail embodiments of this application with reference to accompanying drawings.

Some terms in this application are described below. It should be noted that the descriptions are intended for ease of understanding by a person skilled in the art, but do not constitute a limitation on the protection scope claimed in this application.

### 1. Thermal conductivity

The thermal conductivity is also referred to as a thermal conductivity coefficient or thermal conductivity, and is a physical quantity indicating a heat conduction capability of a material.

### 2. Coefficient of thermal expansion (coefficient of thermal expansion, CTE)

The coefficient of thermal expansion is a physical quantity indicating a thermal expansion degree of a material, and usually means a relative length or size variation of an object of a unit length or unit size when a temperature increases 1°C.

### 3. Heat insulation material

A heat insulation material is a material that can block or reduce heat transfer, and is also referred to as a thermal insulation material.

The foregoing describes some terms used in this application, and the following describes possible application scenarios of this application.

It should be noted that a light source module in this application may also be referred to as an optical module, a laser transmitting module, or the like. All modules including functional components and structures in this application fall within the protection scope of this application. It may be understood that the light source module is merely an example term.

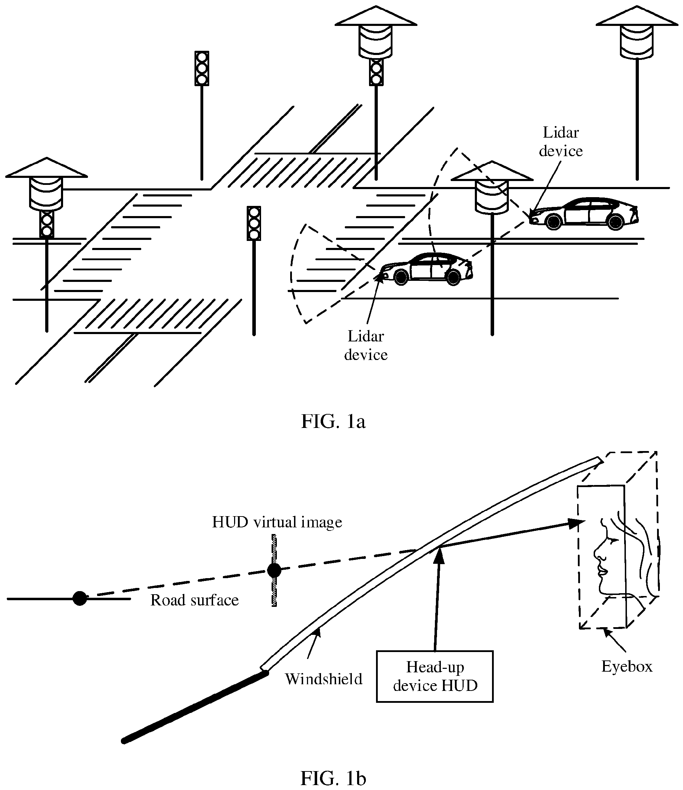

In a possible application scenario, the light source module in this application may be integrated into a lidar device, and the lidar device may be installed on a vehicle. The vehicle may be, for example, an unmanned vehicle, an intelligent vehicle, an electric vehicle, or a digital vehicle. The lidar device may be deployed in various positions of the vehicle. For example, the lidar device may be deployed in any one or more of four directions: front, rear, left, and right of the vehicle, to capture information about an environment around the vehicle. FIG. 1a shows an example in which a lidar device is deployed in front of a vehicle. The lidar device may sense a sector-shaped area shown in a dashed-line box in FIG. 1a, and the sector-shaped area may be referred to as a lidar detection area. A principle of target detection with the lidar device is as follows. The lidar device transmits an optical signal in a specific direction. If a target exists in a detection area of the lidar device, the target may reflect the received optical signal back to the lidar device (reflected light may be referred to as an echo signal), and then the lidar device determines information about the target based on the echo signal. Based on the optical signal transmitted by the lidar device, the lidar device may obtain, in real time or periodically, a latitude, a longitude, a speed, and a direction of the vehicle, or information about a target (for example, another ambient vehicle or an obstacle) in a specific range (for example, a distance of the target, a moving speed of the target, or a posture of the target). The lidar device or the vehicle may determine a position of the vehicle based on the obtained information, and may perform route planning and the like. For example, the position of the vehicle is determined based on the longitude and the latitude, or a driving direction and a destination of the vehicle in a future period of time are determined based on the speed and the direction, or a quantity and density of obstacles around the vehicle are determined based on distances of ambient objects. Further, optionally, based on a function of an advanced driving assistant system (advanced driving assistant system, ADAS), unmanned driving, autonomous driving, assisted driving, intelligent driving, or the like of the vehicle may be implemented.

It should be noted that the lidar device disposed on the vehicle in the foregoing descriptions is merely an example. For example, the lidar device can also be disposed on an unmanned aerial vehicle as an airborne radar. For another example, the lidar device may also be installed on a road side unit (road side unit, RSU) as a roadside traffic lidar device, and may implement intelligent vehicle-road collaborative communication and the like. For another example, the lidar device may be installed on an automated guided vehicle (automated guided vehicle, AGV). The AGV is a transport vehicle that is equipped with an automatic navigation apparatus such as an electromagnetic navigation apparatus or optical navigation apparatus and that can travel along a prescribed navigation route and implement security protection and various transfer functions.

In another possible application scenario, the light source module in this application may alternatively be integrated into a head-up device (head-up device, HUD). Refer to FIG. 1b. FIG. 1b is described by using an example in which an HUD is installed on a vehicle. The HUD may project a formed image (referred to as an HUD virtual image) in a field of view in front of a driver. The image is fused with real road surface information to enhance driver's perception of an actual driving environment. For example, the HUD may superimpose the HUD virtual image carrying navigation information and/or instrument information (for example, a vehicle speed, a rotational speed, a temperature, and a fuel amount) on a real environment outside the vehicle, so that the driver can obtain visual effect of augmented reality. Specifically, the HUD may be applied to scenarios such as augmented reality (augmented reality, AR) navigation, adaptive cruise, and lane departure warning. The HUD includes but is not limited to a windshield (Windshield, W)-HUD, an augmented reality head-up display (augmented reality head-up display, AR-HUD), and the like.

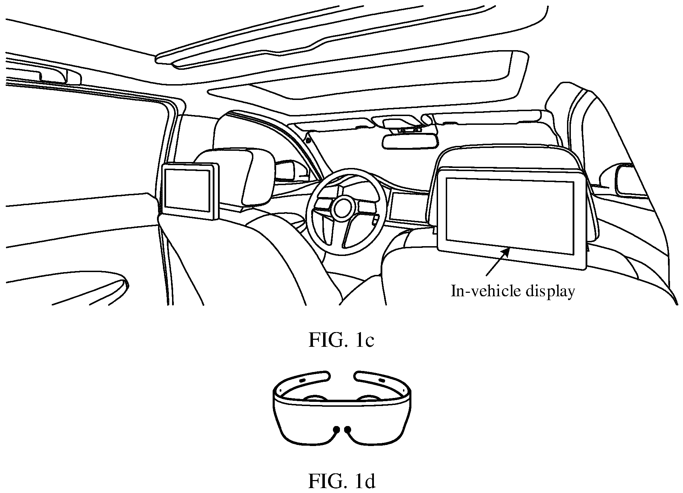

In still another possible implementation, the light source module in this application may alternatively be integrated into an in-vehicle display. Refer to FIG. 1c. The in-vehicle display may be installed on a seat back of a vehicle, may be installed in a position of a front passenger seat, or the like. An installation position of the in-vehicle display is not limited in this application.

In still another possible application scenario, the light source module in this application may alternatively be integrated into a near eye display (near eye display, NED) device. The NED device may be, for example, an AR device or a virtual reality (virtual reality, VR) device. The AR device may include but is not limited to AR glasses or an AR helmet, and the VR device may include but is not limited to VR glasses or a VR helmet. Refer to FIG. 1d. The AR glasses are used as an example. A user may wear an AR glasses device for gaming, video watching, virtual conference, video shopping, telemedicine, or remote training. Other scenarios are not listed herein.

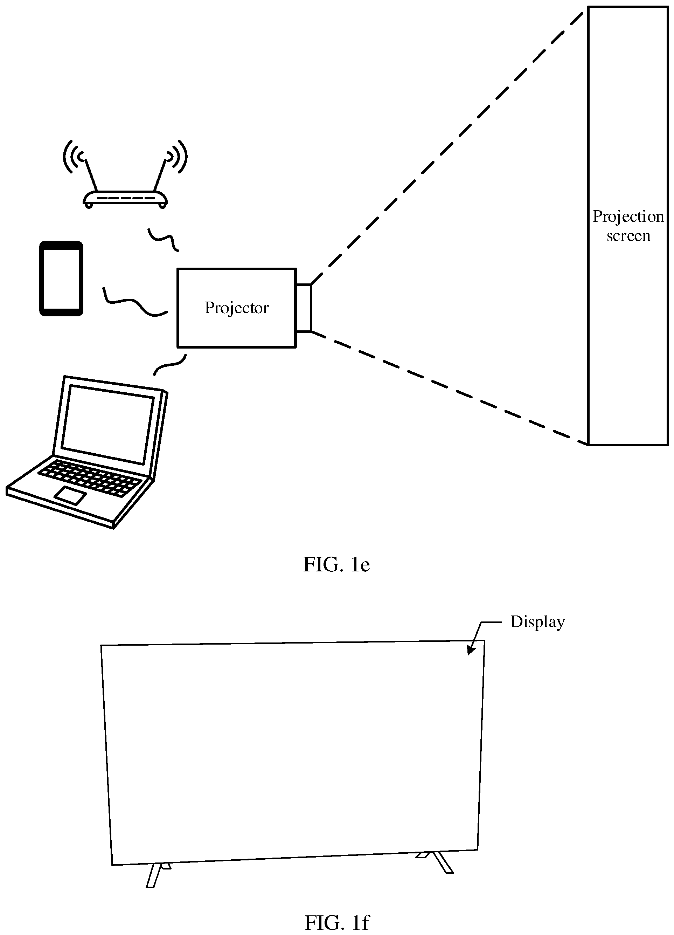

In yet another possible application scenario, the light source module in this application may be integrated into a projector. Refer to FIG. 1e. The projector may project an image onto a wall or a projection screen.

It should be understood that the foregoing possible application scenarios are merely examples, and the light source module is applicable to any scenario that has a high requirement on stability of a light-source temperature. For example, the light source module provided in this application may be further applied to a display as a backlight source. Refer to FIG. 1f. For example, the light source module may also be applied to an aesthetic medicine device and the like.

As described in the background, a center wavelength of an optical signal emitted by a light source in the existing light source module shifts with a temperature change. Moreover, the emitting power of the light source decreases with an increase of the temperature.

In view of this, this application provides a light source module. The light source module can keep a light source of the light source module in a stable temperature range. This helps improve an emitting power of the light source module and stability of a center wavelength of a transmitted optical signal.

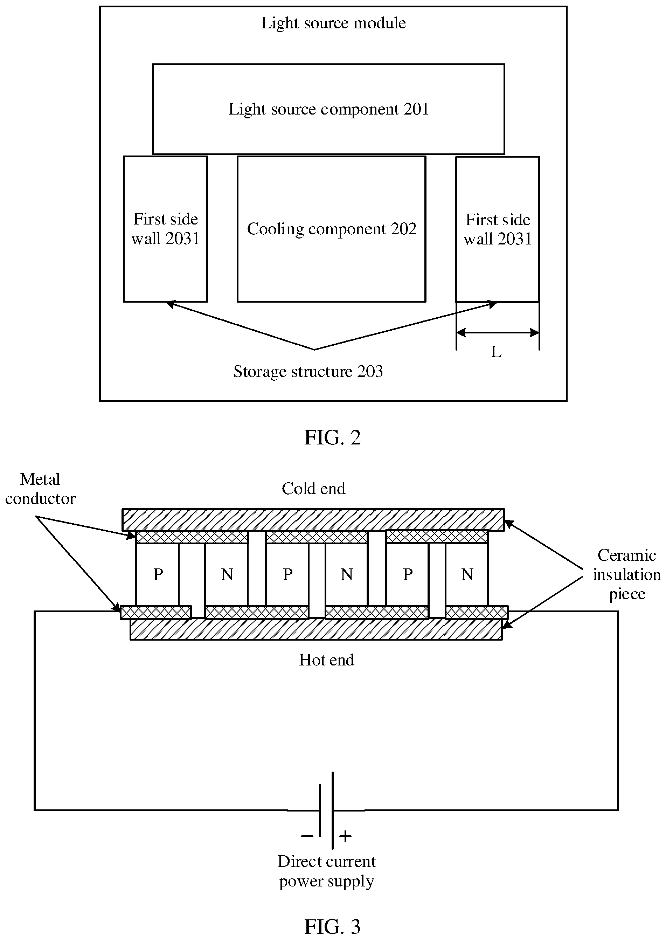

Based on the foregoing content, the following describes the light source module provided in this application in detail with reference to FIG. 2 to FIG. 10.

FIG. 2 is a schematic diagram of a structure of a light source module according to an embodiment of this application. The light source module may include a light source component 201, a cooling component 202, and a storage structure 203. The storage structure 203 includes at least one first side wall 2031. The first side wall 2031 contains at least a part of the cooling component 202. It should be noted that containing in this application means that the first side wall 2031 is disposed on a periphery (or referred to as an outer side) of the cooling component 202.

In a possible implementation, the light source component 201 and the cooling component 202 are stacked. It may also be understood that contact between the light source component 201 and the cooling component 02 may be direct contact or indirect contact. For example, indirect contact may mean that a sandwich structure is disposed, or a thermally conductive adhesive (or referred to as a thermal adhesive) is filled between the light source component 201 and the cooling component 202. "Contact" in the following descriptions may also be understood as direct contact or indirect contact. The thermally conductive adhesive can also be referred to as a thermal adhesive, thermally conductive silica gel, thermally conductive silicone rubber, thermally conductive silicone adhesive, or thermally conductive silicone. An organic silica gel is a main material of the thermally conductive adhesive. The thermally conductive adhesive is obtained through mixing the organic silica gel with added polymer materials such as a filler and a thermally conductive material. The thermally conductive adhesive has good thermal conductivity and electrical insulation performance.

In a possible implementation, the first side wall 2031 may be in contact with the cooling component 202, or a specific gap may exist between the first side wall 2031 and the cooling component 202. FIG. 2 shows an example in which a specific gap exists between the first side wall 2031 and the cooling component 202. It may be understood that a smaller gap between the first side wall 2031 and the cooling component 202 indicates better effect of blocking heat conduction to the light source component 201 by the first side wall 2031. In other words, when a structure of the cooling component 202 is fixed, a larger width L of the first side wall 2031 indicates better effect of blocking heat conduction to the light source component 201 by the first side wall 2031.

It should be noted that, in the example in FIG. 2, the storage structure 203 includes two first side walls 2031, and the two first side walls 2031 are located on two sides of the cooling component 202. A quantity of first side walls 2031 included in the storage structure 203 is not limited in this application.

Based on foregoing light source module, heat of the light source component may be cooled by using the cooling component, and heat conduction to the light source component may be further weakened or blocked (in other words, stopped) by using the storage component. Therefore, the light source component can stay in a stable temperature range, and the light source component can further maintain a stable center wavelength and a stable emitting power.

The following separately describes each function component and structure shown in FIG. 2, to provide an example specific implementation. For ease of description, the light source component, the cooling component, and the storage structure in the following are not marked with numbers.

### 1. Light source component

In a possible implementation, the light source component may include a light source and a substrate. Specifically, the light source is located on the substrate, which may alternatively be understood as that the light source and the substrate are stacked. The substrate drives the light source to emit a light signal.

For example, the light source may be a semiconductor laser, and the semiconductor laser may include but is not limited to a laser diode (laser diode, LD). The laser diode has advantages of high efficiency, small size, long life cycle, and the like. Specifically, for example, the light source may be a vertical cavity surface emitting laser (vertical cavity surface emitting laser, VCSEL), an edge emitting laser (edge emitting laser, EEL), or a diode pumped solid state laser (diode pumped solid state laser, DPSS). The substrate may be a ceramic substrate or a printed circuit board (printed circuit board, PCB).

It may be understood that the light source generates a large amount of heat during operation, which may cause a temperature change of the light source; alternatively, the temperature change of the light source may be caused by a temperature change of an environment of the light source module. At different temperatures, center wavelengths of optical signals emitted by the light source are different. For example, at the temperature T₁°C, a center wavelength of an optical signal emitted by the light source is λ₁, and at the temperature T₂°C, a center wavelength of an optical signal emitted by the light source is λ₂, where λ₁ and X₂ may be different. To stabilize a center wavelength of an optical signal that is output by the light source, effective heat dissipation needs to be performed on the light source.

### 2. Cooling component

In a possible implementation, the cooling component may be, for example, a thermo electric cooler (thermo electric cooler, TEC). The thermo electric cooler is made based on the Peltier effect of semiconductor materials. The Peltier effect means a phenomenon that when a direct current flows through a dipole composed of two semiconductor materials, one end absorbs heat and the other end releases heat. Semiconductor materials of the TEC mainly include heavily doped N-type and P-type bismuth telluride.

FIG. 3 is a schematic diagram of a cooling principle of a TEC according to this application. The TEC includes pairs (sets) of P-type semiconductors and N-type semiconductors connected together by electrodes. The pairs of the P-type semiconductors and the N-type semiconductors are sandwiched between two ceramic electrodes. When a current flows through the TEC, heat generated by the current passes from one side of the TEC to the other. In this case, a "hot" end and a "cold" end are formed on the TEC.

In a possible implementation, the "cold" end of the TEC is configured to contact a light source module, and conduct heat generated by the light source module to the "cold" end of the TEC, so as to dissipate the heat of the light source module. Further, the light source module may be in direct contact or indirect contact with the "cold" end of the TEC. For example, a thermally conductive adhesive or another sandwich structure that may conduct heat is filled between the light source module and the "cold" end of the TEC.

It should be noted that the foregoing TEC is a possible example of the cooling component. A specific structure of the cooling component is not limited in this application. Any structure that can conduct the heat of the light source component may be referred to as a cooling component.

### 3. Storage structure

In a possible implementation, the storage structure may include at least one first side wall. The first side wall may contain a part of the cooling component, and may be configured to weaken or block heat conduction to the light source component.

Further, optionally, the first side wall may be of a "strip" type, which may also be referred to as a "line" type. Alternatively, the first side wall may be of an "L" type, where the "L" type may include but is not limited to a regular "L" type, or an irregular "L" type (which may be referred to as an "L-like" type), for example, an "L"-like type with an arc or the like. Alternatively, the first side wall may be of a "Π" type, or the like. A specific shape of the first side wall is not limited in this application. A structure of the first side wall of the "strip" type is simple to manufacture, and therefore packaging of the light source module is simplified.

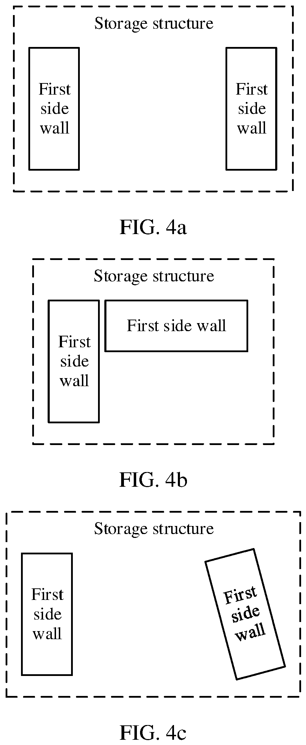

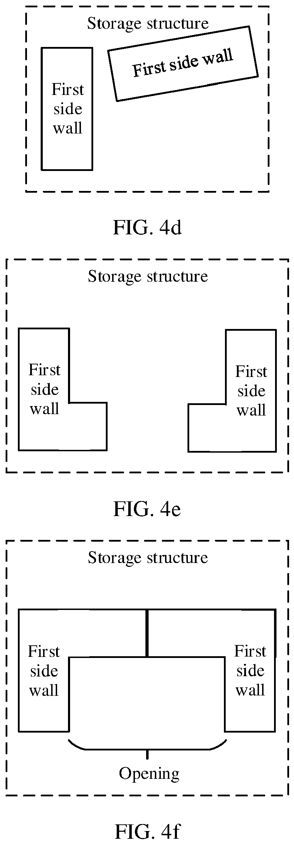

For example, the storage structure includes two first side walls. Specifically, the two first side walls of the "strip" type may be parallel (refer to FIG. 4a); or the two first side walls may be perpendicular (refer to FIG. 4b), and there may be a specific gap between the two perpendicular side walls; or the two side walls may be in contact. This is not limited in this application. Alternatively, there may be a specific included angle between the two side walls (refer to FIG. 4c or FIG. 4d). The two side walls between which there is a specific included angle may be in contact, or there may be a specific gap. This is not limited in this application. It should be noted that the position relationships between the two first side walls provided above are merely examples, and the position relationship between the two first side walls is not limited in this application.

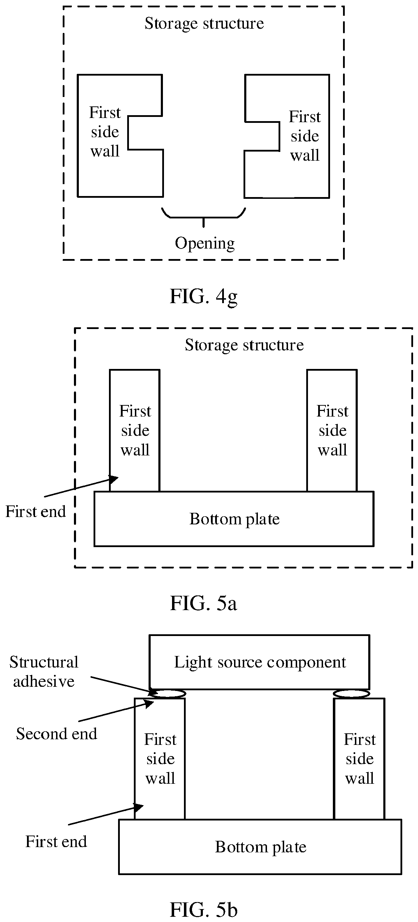

For example, the storage structure includes two first side walls. Specifically, the two first side walls of the "L" type or the "L-like" type may form a "square" shape with an opening (refer to FIG. 4e or FIG. 4f). An area of the opening may be used for passage of an optical signal or the like. For another example, the two first side walls of the "Π" type may also form a "square" with an opening (refer to FIG. 4g).

It should be noted that a quantity of first side walls included in the storage structure is not limited in this application. The foregoing descriptions are merely possible examples in which the storage structure includes two first side walls.

For example, the first side wall is of the "strip" type, and one first side wall may contain one side of the cooling component. For example, the first side walls are of the "strip" type. The two first side walls may contain two sides of the cooling component, and may be specifically two opposite sides (refer to FIG. 4a or FIG. 4c) or two connected sides (refer to FIG. 4b or FIG. 4d).

For ease of describing the solution, an example in which the first side wall is of the "strip" type and the storage structure includes two first side walls is used below.

In a possible implementation, the storage structure further includes a bottom plate. FIG. 5a is a schematic diagram of a position relationship between first side walls and a bottom plate according to this application. The bottom plate is in contact with first ends of the two first side walls separately. It may be understood that the first side walls may be in direct contact with the bottom plate. Alternatively, the first side walls may be in indirectly contact with the bottom plate. For example, a structural adhesive or another heat insulation sandwich structure is filled between the bottom plate and the first side wall. It should be noted that, in actual product design, the bottom plate may belong to or does not belong to the light source module. If the bottom plate does not belong to the light source module, there may be a structure that is similar to the bottom plate and that matches the foregoing light source module in the product. The structure similar to the bottom plate may have other functions in addition to matching the light source module, and is also referred to as a "bottom plate" herein. The light source module and the bottom plate may be collectively referred to as an optical module. It should be noted that the structural adhesive usually is an adhesive featured by high strength (for example, compressive strength is greater than 65 megapascals (MPa), steel-steel adhesion strength is greater than 30 MPa, and shear strength is greater than 18 MPa), high load capacity, aging resistance, fatigue resistance, corrosion resistance, and stable performance within an expected life cycle.

Further, optionally, second ends of the first side walls are connected to the light source component. For details, refer to FIG. 5b. In a possible manner, the second ends of the first side walls are connected to the light source component by using the structural adhesive, and the second ends of the first side walls are opposite to the first ends of the first side walls. Based on this connection manner, the first side walls and the light source component are connected by using the structural adhesive. This helps improve strength of the light source module, and can further increase heat that is of the light source component and that is transmitted to the outside of the light source component. In another possible manner, the second ends of the first side walls are connected to the light source component through welding. By welding the second ends of the first side walls and the light source component, the strength of the light source module is improved.

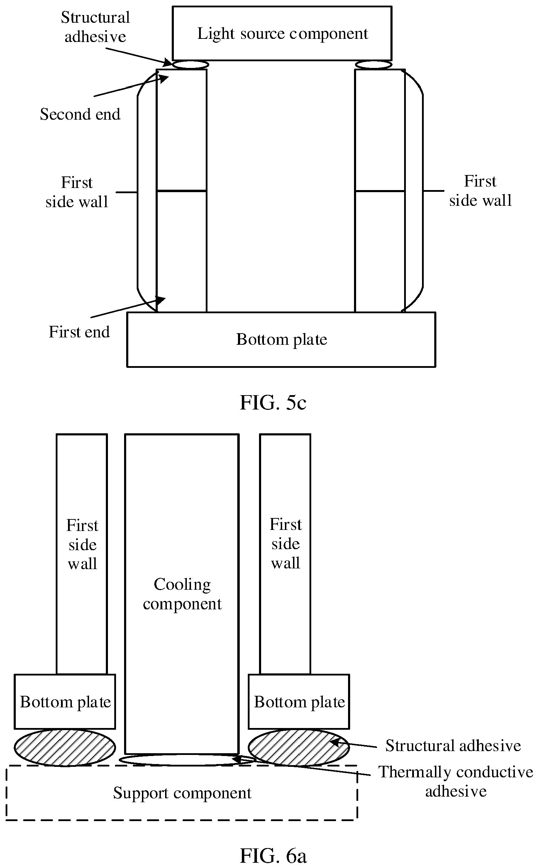

In a possible implementation, the first side wall may be a single-layer wall (as shown in FIG. 5b), or may be a multi-layer wall as shown in FIG. 5c. FIG. 5c shows an example in which the first side wall is a two-layer wall. It should be noted that a quantity of layers of the first side wall included in the storage structure is not limited in this application. It may be understood that a larger quantity of layers of the first side wall indicates a thicker first side wall, and better effect of blocking heat conduction to the light source component by the first side wall.

In a possible implementation, a thermal conductivity of a material of the bottom plate is higher than a thermal conductivity of a material of the first side wall. The first side wall formed by a material of a low thermal conductivity can effectively weaken or block heat conduction to the light source component. Further, the bottom plate formed by using a material of a high thermal conductivity helps further conduct heat of the light source component outward from the light source component, that is, helps improve the heat dissipation effect on the light source component.

Further, optionally, the thermal conductivity of the material of the first side wall is smaller than a second threshold, where the second threshold is related to a cooling range of the cooler and heat returned by the first side wall. Further, the second threshold needs to meet a requirement that the heat returned to the light source component through the first side wall does not cause temperature control effect of the TEC to exceed a target range. It may also be understood that the thermal conductivity of the material of the first side wall can reduce the heat conducted to the light source component as much as possible. Even if a small amount of heat is conducted to the light source component, effective temperature control can be implemented by re-cooling of the cooling component. Therefore, the light source component is in a stable temperature range.

Specifically, the material of the first side wall may be a heat insulation material, and/or the material of the bottom plate may be a heat conduction material. For example, the material of the first side wall may include, but is not limited to, any one or a combination of glass or acrylic. The material of the bottom plate may include, but is not limited to, any one or any combination of Kovar alloy, tungsten copper alloy, invar, copper, and the like.

It should be noted that the materials of the first side wall and the bottom plate are merely examples. The materials of the first side wall and the bottom plate are not limited in this application. Any material that is used for the bottom plate to conduct heat of the light source component outward, and/or a material that is used for the first side wall to weaken or block heat conduction to the light source component shall fall within the protection scope of this application.

Based on whether the bottom plate includes an opening, the following shows two possible position relationships between the storage structure and the cooling component in different cases as examples.

Case 1: The bottom plate includes an opening.

FIG. 6a is a schematic diagram of a position relationship between a bottom plate and a cooling component according to this application. The bottom plate includes an opening for passage of the cooling component. It may also be understood that the cooling component may pass through the opening of the bottom plate and contact with a support component. Further, thermally conductive adhesive is filled between the cooling component and the support component. Because the cooling component passes through the opening, a heat dissipation path can be shortened. This helps improve stability of a temperature of the light source component.

Case 2: There is no opening on the bottom plate.

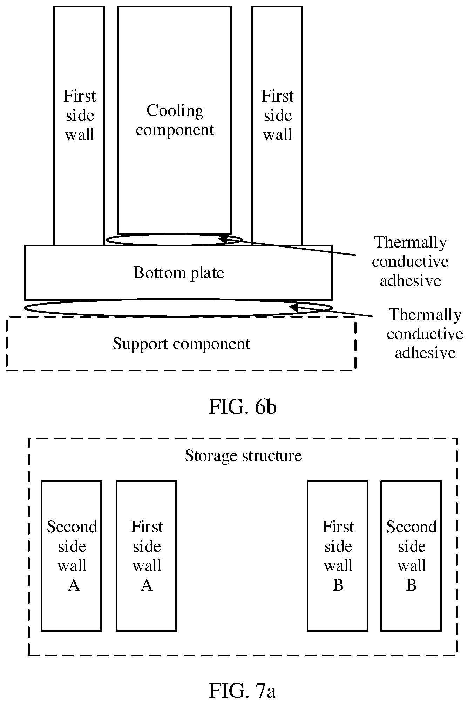

FIG. 6b is a schematic diagram of another position relationship between a bottom plate and a cooling component according to this application. The bottom plate may be in contact with the cooling component. To further improve the heat dissipation effect of the light source component, a thermally conductive adhesive is filled between the bottom plate and the cooling component.

In a possible implementation, the storage structure further includes at least one second side wall. The at least one second side wall contains at least a part of the first side wall. Refer to FIG. 7a. For example, the storage structure includes two second side walls. The storage structure includes two second side walls (a second side wall A and a second side wall B) and two first side walls (a first side wall A and a first side wall B). The second side wall A contains the first side wall A, and the second side wall B contains the first side wall B.

It should be noted that the first side wall may be in contact with the second side wall, or may not be in contact with the second side wall. It may be understood that, when the first side wall is not in contact with the second side wall, returned heat passing through the second side wall is dissipated through air. In this case, effect of blocking heat conduction to the light source component by the first side wall is further improved.

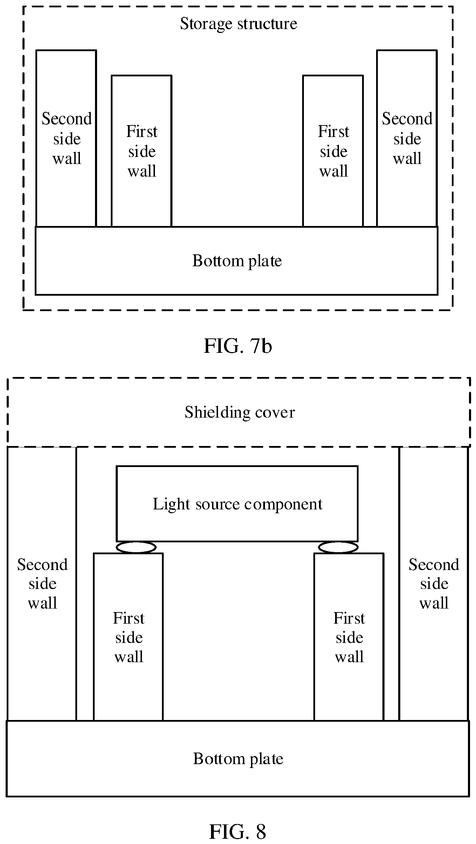

FIG. 7b is a schematic diagram of a structure of another storage structure according to an embodiment of this application. The storage structure may include a first side wall, a second side wall, and a bottom plate. A first end of the first side wall is in contact with the bottom plate, and a first end of the second side wall is also in contact with the bottom plate. In a possible implementation, the bottom plate and the second side wall may be integrally formed. A structure of an integration formed by the second side wall and the bottom plate may be referred to as a package housing, and the first side wall and a cooling component may be packaged in the package housing.

In a possible implementation, the second side wall is higher than the first side wall. Further, the second side wall may be higher than the light source component, or may be of a same height as the light source component, so that the second side wall may further include the light source component. It may also be understood that the light source component may be packaged in the package housing. Refer to FIG. 8.

In a possible implementation, the material of the second side wall may include, but is not limited to, any one or any combination of Kovar alloy, tungsten copper alloy, invar, copper, or the like.

In a possible implementation, there is a gap between the second side wall and the substrate of the light source component, and a width of the gap, for example, is not less than 0.5 millimeters (mm). In this way, heat conduction to the light source component can be further blocked or weakened. In addition, space required for thermal expansion of the substrate and the second side wall is reserved.

In a possible implementation, a difference between any two of a coefficient of thermal expansion of the substrate of the light source component, a coefficient of thermal expansion of the second side wall, and a coefficient of thermal expansion of the first side wall is less than a first threshold. For example, the first threshold may be 10 ppm. For details, refer to displacement tolerance of the substrate. In this way, it can be ensured that the coefficients of thermal expansion of the first side wall, the second side wall, and the substrate are adapted. This helps avoid problems, such as fracture or warpage, that occur at different temperatures and that are caused by a difference between the coefficients of thermal expansion of the first side wall, the substrate, and the second side wall. It should be noted that close coefficients of thermal expansion of the first side wall, the substrate, and the second side wall are preferred.

Further, optionally, the light source module may further include a shielding cover (refer to FIG. 8), and the shielding cover is electrically connected to the bottom plate or the second end of the second side wall. In this way, electromagnetic radiation can be shielded for the light source module.

In a possible implementation, a component that supports the light source module and dissipates heat from the light source component may be referred to as a support component. The support component may be a component dedicated to supporting the light source module and dissipating heat of the light source module, for example, may be a thermally conductive support. Alternatively, the support component may be another structure around the light source module that can support the light source module and dissipate heat of the light source module. It may also be understood that heat in the light source module may be dissipated by using the support component, so that the light source is at a stable temperature.

Based on the foregoing case 1, a thermally conductive adhesive is filled between the cooling component and the support component, and a structural adhesive is filled between the non-opening area of the bottom plate and the support component. For details, refer to FIG. 6a. The thermally conductive adhesive is filled between the cooling component and the support component, so that the cooling component can effectively conduct heat of the light source component outward. The structural adhesive is filled between the non-opening area of the bottom plate and the support component. This helps improve strength of the light source module.

Based on the foregoing case 2, thermally conductive adhesive may also be filled between the bottom plate and the support component (refer to FIG. 6b), to further improve heat dissipation effect on the light source component.

In another possible implementation, the component used for dissipating heat conducted by the light source component (in other words, conducting the heat of the light source module to the outside of the light source module) may be a heat sink. The heat sink is any object that can dissipate heat from the light source component, and a temperature of the heat sink does not change with an amount of heat transferred to the heat sink. The heat sink may include but is not limited to objects such as atmosphere and ground, or may be a copper column with a high thermal conductivity, or the like.

Based on the foregoing content, the following provides two specific implementations of the foregoing light source module, so that the structure of the foregoing light source module and an implementation process of heat dissipation of the light source module can be further understood. It should be noted that, if there is no special description or logic conflict, the foregoing functional components and structures may be combined, according to an internal logical relationship, to form another possible ion trap system. Specific implementations of the two light source modules provided below are merely examples.

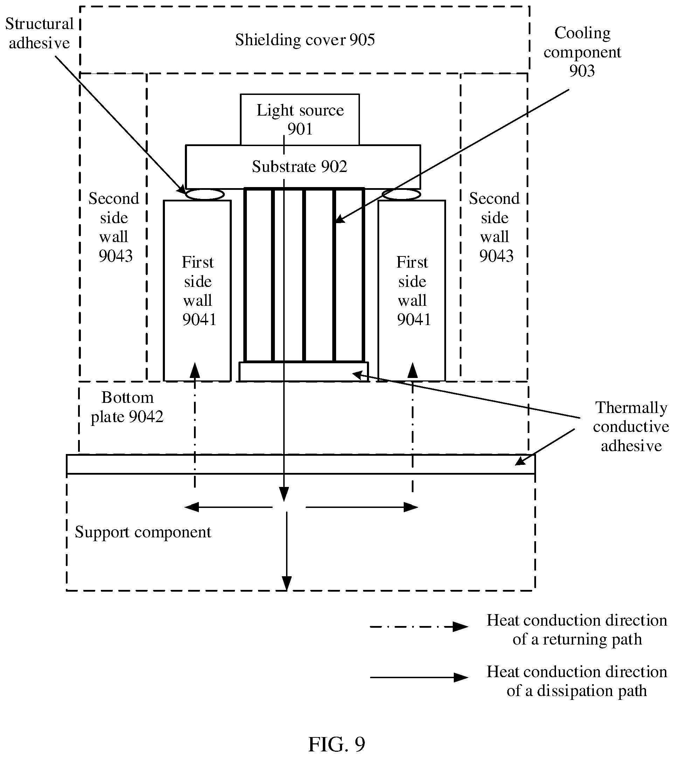

FIG. 9 is a schematic diagram of a structure of another light source module according to an embodiment of this application. The light source module may include a light source 901, a substrate 902, a cooling component 903, and a storage structure 904 (the identifier is not shown in the figure). For example, the storage structure 904 includes two first side walls 9041. Further, the light source 901, the substrate 902, and the cooling component 903 are stacked. Further, optionally, the storage structure 904 may further include a bottom plate 9042. The two first side walls 9041 and the bottom plate 9042 contain the cooling component 903. Specifically, a first end of the first side wall 9041 is in contact with the bottom plate 9042 (the contact may be direct contact or indirect contact). A second end of the first side wall 9041 is connected to the substrate 902 by using a structural adhesive. A thermally conductive adhesive is filled between the cooling component 903 and the bottom plate 9042, and the thermally conductive adhesive is also filled between the bottom plate 9042 and a support component.

Further, optionally, the storage structure 904 may further include a second side wall 9043, and a first end of the second side wall 9043 is in contact with the bottom plate. In an example, the two second side walls 9043 and the bottom plate 9042 are integrally formed, and a structure obtained through integration may be referred to as a package housing.

Further, optionally, the light source module may further include a shielding cover 905, and the shielding cover 905 is electrically connected to a second end of the second side wall 9043.

It should be noted that, for detailed descriptions of the functional components and structures in FIG. 9, refer to the foregoing related descriptions. Details are not described herein.

Based on the foregoing FIG. 9, a heat conduction direction of the light source 901 may be represented by an arrow. Heat conduction mainly includes heat conduction in a heat dissipation path and heat conduction in a returning path. On the heat dissipation path, heat of the light source 901 is transmitted to the support component after passing through the substrate 902, the cooling component 903, and the thermally conductive adhesive. The support component dissipates heat from the light source module in all directions, and a heat conduction direction of part of heat is a direction of the light source 902. In the returning path, heat conduction to the light source can be effectively blocked by the first side wall 9041. This helps maintain temperature stability of the light source. It may be understood that, lower heat in the returning path indicates lower heat conduction to the light source and a higher reliability of the light source module.

It should be noted that, in the heat dissipation path, the thermally conductive adhesive is used for connection or bonding of the structures, to ensure good heat dissipation. In the returning path, the structural adhesive is used for connection or bonding of the structures, to ensure bonding strength.

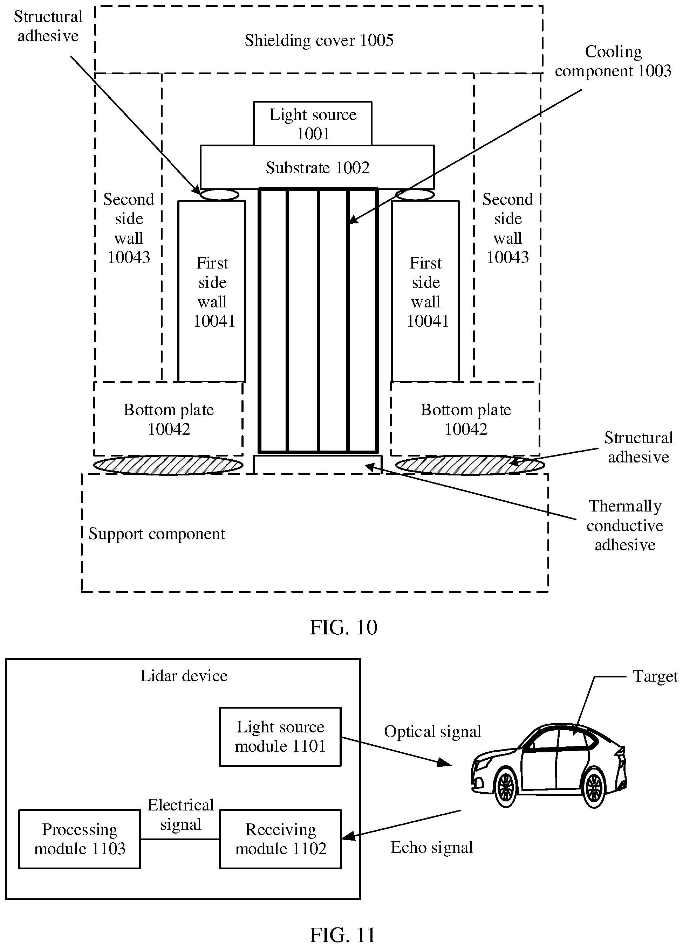

FIG. 10 is a schematic diagram of a structure of still another light source module according to an embodiment of this application. The light source module may include a light source 1001, a substrate 1002, a cooling component 1003, and a storage structure 1004 (the identifier is not shown in the figure). For example, the storage structure 1004 includes two first side walls 10041. Further, the light source 1001, the substrate 1002, and the cooling component 1003 are stacked. Further, optionally, the storage structure 1004 further includes a bottom plate 10042, where the bottom plate 10042 includes an opening. The cooling component 1003 passes through the opening of the bottom plate 10042 and contacts with a support component. Further, optionally, a thermally conductive adhesive is filled between the support component and the cooling component 1003 passing through the opening of the bottom plate 10042. Further, optionally, the structural adhesive is filled between a non-opening area of the bottom plate and the support component. A first end of the first side wall 10041 is in contact with the bottom plate 10042, and a second end of the first side wall 10041 is connected to the substrate 1002 by using the structural adhesive.

Further, optionally, the storage structure 1004 may further include a second side wall 10043, and a first end of the second side wall 10043 is in contact with the bottom plate. In an example, the two second side walls 10043 and the bottom plate 10042 are integrally formed, and a structure obtained through integration may be referred to as a package housing.

Further, optionally, the light source module may further include a shielding cover 1005, and the shielding cover 1005 is electrically connected to a second end of the second side wall 10043.

It should be noted that, for detailed descriptions of the functional components and structures in FIG. 10, refer to the foregoing related descriptions. Details are not described herein.

Based on the light source module shown in FIG. 10, the cooling component may directly conduct heat of the light source to the support component by using the thermally conductive adhesive. Because the heat dissipation path is short, effect of conducting heat of the light source to the support component can be further improved.

It should be understood that shapes of the structural adhesive and the thermally conductive adhesive in the accompanying drawings in the foregoing embodiments are merely examples, and this is not limited in this application.

Based on the foregoing described structure and function principles of the light source module, this application may further provide a detection device. The detection device may include the light source module in any one of the foregoing embodiments. In other words, the light source module provided in embodiments of this application may be used for all detection devices that need to control temperature stability of a light source in a light source module.

In a possible implementation, the detection device may further include another module, for example, a receiving module, configured to receive an echo signal corresponding to an optical signal, where the echo signal is used to obtain association information of a target detected by the detection device.

Example 1: The detection device may be a lidar device. FIG. 11 is a schematic diagram of a structure of a lidar device according to an embodiment of this application. The lidar device may include a light source module 1101 and a receiving module 1102 in any one of the foregoing embodiments. Further, optionally, the lidar device may further include a processing module 1103. The light source module 1101 is configured to transmit an optical signal to a detection area, where the optical signal is transmitted by a target in the detection area to obtain an echo signal. The receiving module 1102 is configured to receive an echo signal. Further, optionally, the receiving module 1102 may be further configured to perform optical-to-electrical conversion on the echo signal, to obtain an electrical signal used to determine association information of a target. Further, the receiving module 1102 sends an electrical signal to the processing module 1103. The processing module 1103 can determine association information of a target based on a received electrical signal. The association information of the target may include but is not limited to distance information of the target, a direction of the target, a speed of the target, and/or grayscale information of the target.

In a possible implementation, the receiving module may include an optical receiving lens, and may further include a detector. The optical receiving lens is used to collect echo signals as much as possible and transmit the collected echo signals to the detector. The optical receiving lens includes at least one lens. The lens in the optical receiving lens may be a single spherical lens, or may be a combination of a plurality of spherical lenses (for example, a combination of concave lenses, a combination of convex lenses, or a combination of convex and concave lenses), or may be a single aspheric lens, or may be a combination of a plurality of aspheric lenses. A combination of a plurality of spherical lenses and/or aspherical lenses helps improve imaging quality of the lidar device, and reduces aberration of the lidar device. It may be understood that the convex lens and the concave lens may be of various types. For example, the convex lens includes a biconvex lens, a plano-convex lens, and a meniscus lens, and the concave lens includes a biconcave lens, a plano-concave lens, and a meniscus lens.

Further, optionally, a material of the lens in the optical receiving lens may be an optical material such as glass, resin, or crystal. When the material of the lens is the resin, a weight of the lidar device can be reduced. When the material of the lens is glass, the imaging quality of the lidar device can be further improved. Further, to effectively suppress temperature drift, the optical lens includes at least one lens of a glass material.

In a possible implementation, the detector may include but is not limited to a single-photon avalanche diode (single-photon avalanche diode, SPAD) array, a digital silicon photomultiplier (silicon photomultiplier, SiPM) array, an avalanche photodiode (avalanche photodiode, APD), or the like.

In a possible implementation, the processing module may include one or more processing units. The processing unit may be, for example, a central processing unit (central processing unit, CPU) or another general-purpose processor, a field programmable gate array (field programmable gate array, FPGA), an application processor (application processor, AP), a graphics processing unit (graphics processing unit, GPU), an image signal processor (image signal processor, ISP), a controller, a digital signal processor (digital signal processor, DSP), an application specific integrated circuit (application specific integrated circuit, ASIC), another programmable logic device, transistor logic device, hardware component, or any combination thereof. The general-purpose processor may be a microprocessor, or may be any conventional processor. Different processing units may be independent components, or may be integrated into one or more processors.

It should be noted that the structure of the lidar device in the foregoing descriptions is merely an example. In another possible example, the lidar device may include more, fewer or different modules, and each module may include more, fewer or different components.

Example 2: The detection device may be a fusion sensor. The fusion sensor may have functions of the foregoing lidar device and a camera. In a possible implementation, the fusion sensor may further include an image obtaining module, to obtain image information.

It should be noted that the foregoing two examples of the detection device are merely used to facilitate solution description. A specific form and name of the detection device are not limited in this application.

Based on the foregoing described structure and function principles of the detection device, this application may further provide a terminal device. The terminal device may include the detection device in any one of the foregoing embodiments. Further, optionally, the terminal device may further include a processor configured to plan a driving route based on association information and/or image information of a target.

For example, the terminal device may include but is not limited to a vehicle (for example, an unmanned vehicle, an intelligent vehicle, an electric vehicle, or a digital vehicle), a robot, a surveying and mapping device, an unmanned aerial vehicle, a smart home device (for example, a robot vacuum), a smart manufacturing device (for example, an industrial device), a smart transport device (for example, an automated guided vehicle (automated guided vehicle, AGV), an unmanned transport vehicle, or a truck), a ship, or the like.

The following uses a vehicle as an example to describe a function block diagram of a vehicle installed (in other words, integrated) with a detection device. In the structure of the vehicle, the detection device may be referred to as a sensor system.

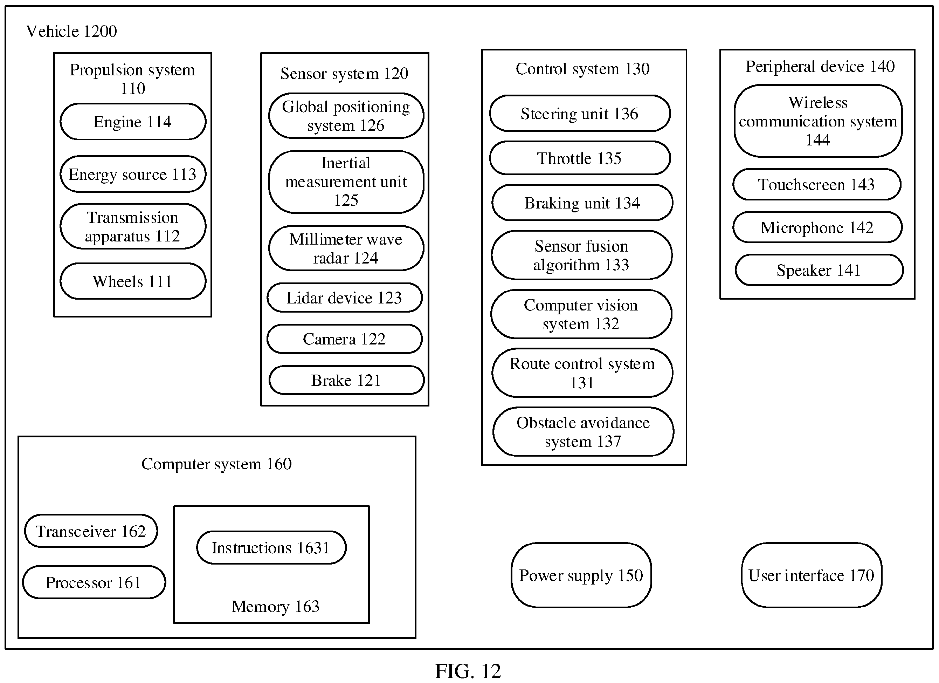

FIG. 12 is an example function block diagram of a vehicle according to this application. Components coupled to or included in a vehicle 1200 may include a propulsion system 110, a sensor system 120, a control system 130, a peripheral device 140, a power supply 150, a computer system 160, and a user interface 170. The components of the vehicle 1200 may be configured to interconnect with each other and/or with other components that are coupled to various systems for operation. For example, the power supply 150 may provide power to all components of the vehicle 1200. The computer system 160 may be configured to receive data from and control the propulsion system 110, the sensor system 120, the control system 130, and the peripheral device 140. The computer system 160 may be further configured to display an image generated on the user interface 170, and receive input from the user interface 170.

The propulsion system 110 powers motion of the vehicle 1200. The propulsion system 110 may include an engine/motor 114, an energy source 113, a transmission (transmission) apparatus 112, and wheels/tires 111. In addition, the propulsion system 110 may additionally or alternatively include components other than those shown in FIG. 11. This is not specifically limited in this application.

The sensor system 120 may include several sensors for sensing information and the like of an environment of the vehicle 1200. For example, a sensor of the sensor system 120 may include, but is not limited to, a global positioning system (Global Positioning System, GPS) 126, an inertial measurement unit (Inertial Measurement Unit, IMU) 125, a millimeter wave radar 124, a lidar device 123, a camera 122, and a brake 121 that is used for modifying a position and/or orientation of a sensor. The millimeter wave radar 124 may use a radio signal to sense a target in the ambient environment of the vehicle 1200. In some embodiments, in addition to sensing the target, the millimeter wave radar 124 may also be used to sense a speed and/or direction of movement of the target. The lidar device 123 may sense, by using laser, a target in the environment of the vehicle 1200. In some embodiments, the lidar device 123 may include one or more laser sources, a scanner, one or more detectors, and other system components. The camera 122 may be configured to capture a plurality of images of the ambient environment of the vehicle 1200. The camera 122 may be a static camera or a video camera.

The sensor system 120 may also include a sensor (for example, an in-vehicle air quality monitor, a fuel gauge, an oil temperature gauge) of an internal system of the monitored vehicle 1200. Sensor data from one or more of these sensors may be used to detect an object and corresponding characteristics (a position, a shape, a direction, a speed, and the like) of the object. Such detection and identification are key functions for safe operation of the vehicle 1200. The sensor system 120 may also include other sensors. This is not specifically limited in this application.

The GPS 126 may be any sensor used to estimate a geographical position of the vehicle 1200. In this case, the GPS 126 may include a transceiver that estimates the position of the vehicle 1200 relative to the Earth based on satellite positioning data. In an example, the computer system 160 may be configured to estimate, by using the GPS 126 with reference to map data, a road on which the vehicle 1200 is traveling. The IMU 125 may be configured to sense a change in the position and the direction of the vehicle 1200 based on inertial acceleration and any combination thereof. In some examples, a combination of sensors in the IMU 125 may include, for example, an accelerometer and a gyroscope. In addition, there is another possible combination of the sensors in the IMU 125.

The control system 130 controls operations of the vehicle 1200 and the components of the vehicle 1200. The control system 130 may include various components, including a steering unit 136, a throttle 135, a braking unit 134, a sensor fusion algorithm 133, a computer vision system 132, a route control system 131, and an obstacle avoidance system 137. The steering system 136 is operable to adjust a direction of movement of the vehicle 1200. For example, in an embodiment, the steering system 136 may be a steering wheel system. The throttle 135 is configured to control an operating speed of the engine 114, to further control the speed of the vehicle 1200. The control system 130 may additionally or alternatively include components other than those shown in FIG. 11. This is not specifically limited in this application.

The braking unit 134 is used to control deceleration of the vehicle 1200. The braking unit 134 may use friction to decelerate the wheels 111. In another embodiment, the braking unit 134 may convert kinetic energy of the wheels 111 into a current. The braking unit 134 may alternatively reduce a rotational speed of the wheels 111 in another manner, to control the speed of the vehicle 1200. The computer vision system 132 may be operated to process and analyze an image captured by the camera 122, to recognize a target and/or a feature in the ambient environment of the vehicle 1200. The target and/or feature may include a traffic signal, a road boundary, and an obstacle. The computer vision system 132 may use a target recognition algorithm, a structure from motion (Structure from Motion, SFM) algorithm, video tracking, and another computer vision technology. In some embodiments, the computer vision system 132 may be configured to: draw a map for an environment, track a target, estimate a speed of a target, and the like. The route control system 131 is configured to determine a traveling route of the vehicle 1200. In some embodiments, the route control system 142 may determine the traveling route of the vehicle 1200 based on data from the sensor system 120, the GPS 126, and one or more predetermined maps. The obstacle avoidance system 137 is configured to recognize, evaluate, and avoid a potential obstacle in the environment of the vehicle 1200, or cross over a potential obstacle in another manner. In an instance, the control system 130 may additionally or alternatively include a component other than those shown and described, or some of the foregoing components may not be included.

The peripheral device 140 may be configured to allow the vehicle 1200 to interact with an external sensor, another vehicle, and/or a user. The peripheral device 140 may include a wireless communication system 144, a touchscreen 143, a microphone 142, and/or a speaker 141. The peripheral device 140 may additionally or alternatively include components other than those shown in FIG. 11. This is not specifically limited in this application.

In some embodiments, the peripheral device 140 provides a means for a user of the vehicle 1200 to interact with the user interface 170. For example, the touchscreen 143 may provide information for the user of the vehicle 1200. The user interface 170 may further operate the touchscreen 143 to receive an input from the user. In another case, the peripheral device 140 may provide a means for the vehicle 1200 to communicate with another device in the vehicle. For example, the microphone 142 may receive an audio (for example, a voice command or another audio input) from the user of the vehicle 1200. Likewise, the speaker 141 may output an audio to the user of the vehicle 1200.

The wireless communication system 144 may wirelessly communicate with one or more devices directly or through a communication network. For example, the wireless communication system 144 may use 3G cellular communication, such as code division multiple access (code division multiple access, CDMA), EVD0, global system for mobile communications (global system for mobile communications, GSM)/general packet radio service (general packet radio service, GPRS), or 4G cellular communication, for example, long term evolution (long term evolution, LTE), or 5G cellular communication. The wireless communication system 144 may communicate with a wireless local area network (wireless local area network, WLAN) through Wi-Fi. In some embodiments, the wireless communication system 144 may directly communicate with a device through an infrared link, Bluetooth, or ZigBee. Other wireless protocols, for example, various vehicle communication systems, such as the wireless communication system 144, may include one or more dedicated short range communications (dedicated short range communications, DSRC) devices, and these devices may include public and/or private data communication between the vehicle and/or roadside stations.

The power supply 150 may be configured to provide power to some or all of the components of the vehicle 1200. Therefore, the power supply 150 may include, for example, a rechargeable lithium-ion or lead-acid battery. In some examples, one or more battery packs may be configured to provide power. There may be another power supply material and configuration. In some examples, the power supply 150 and the energy source 113 may be implemented together, as in some all-electric vehicles. The components of the vehicle 1200 may be configured to interconnect with other components within and/or outside respective systems of the components. Therefore, the components and system of the vehicle 1200 may be communicatively linked together via a system bus, a network, and/or another connectivity mechanism.

Some or all of functions of the vehicle 1200 are controlled by the computer system 160. The computer system 160 may include at least one processor 161. The processor 161 executes instructions 1631 stored in a non-transitory computer-readable medium, for example, a memory 163. The computer system 160 may be a plurality of computing devices that control an individual component or a subsystem of the vehicle 1200 in a distributed manner.

The processor 161 may be any conventional processor like a central processing unit (central processing unit, CPU). Optionally, the processor may be a dedicated device such as an application specific integrated circuit (application specific integrated circuit, ASIC) or another hardware-based processor. Although FIG. 12 functionally illustrates the processor, the memory, and another component of the computer system 160 in a same block, a person of ordinary skill in the art should understand that the processor, the computer, or the memory may actually include a plurality of processors, computers, or memories that may or may not be stored in a same physical housing. For example, the memory may be a hard disk drive or another storage medium located in a housing different from the computer system 160. Therefore, it is understood that a reference to the processor or the computer includes a reference to a set of processors or computers or memories that may or may not operate in parallel. Instead of using a single processor to perform the steps described herein, some components such as a steering component and a deceleration component may include respective processors. The processor performs only computation related to a component-specific function.

In various aspects described herein, the processor may be located far from the vehicle and wirelessly communicate with the vehicle. In another aspect, some processes described herein are performed on the processor disposed inside the vehicle, while others are performed by a remote processor, including performing steps necessary for single manipulation.

In some embodiments, the memory 163 may include the instructions 1631 (for example, program logic), and the instructions 1631 may be executed by the processor 161 to perform various functions of the vehicle 1200, including the functions described above. The memory 163 may also include additional instructions, including instructions to send data to, receive data from, interact with, and/or control one or more of the propulsion system 110, the sensor system 120, the control system 130, and the peripheral device 140.

In addition to the instructions 1631, the memory 163 may store data, such as a road map, route information, data detected by a sensor, the position of the vehicle, the direction of the vehicle, the speed of the vehicle, other vehicle data as such, and other information. Such information may be used by the vehicle 1200 and the computer system 160 during operation of the vehicle 1200 in an autonomous, semi-autonomous, and/or manual mode.

The user interface 170 is configured to provide information to or receive information from the user of the vehicle 1200. Optionally, the user interface 170 may be included in one or more input/output devices in a set of the peripheral device 140, for example, the wireless communication system 144, the touchscreen 143, the microphone 142, and the speaker 141.

The computer system 160 may control the functions of the vehicle 1200 based on an input received from various subsystems (for example, the propulsion system 110, the sensor system 120, and the control system 130) and from the user interface 170. For example, the computer system 160 may utilize an input from the control system 130 to control the steering unit 136, to avoid an obstacle detected by the sensor system 120 and the obstacle avoidance system 137. In some embodiments, the computer system 160 is operable to provide control over many aspects of the vehicle 1200 and the subsystems of the vehicle 1200.

Optionally, one or more of the foregoing components may be separated from or associated with the vehicle 1200. For example, the memory 163 may be partially or totally separated from the vehicle 1200. The foregoing components may be communicatively coupled in a wired and/or wireless manner.

It should be noted that the vehicle function framework shown in FIG. 12 is merely an example. In another example, the vehicle 1200 may include more, fewer, or different systems, and each system may include more, fewer, or different components. In addition, the illustrated systems and components may be combined or divided in any manner. This is not specifically limited in this application.

Based on the foregoing described structure and function principles of the light source module, this application may further provide an optical display device. The optical display device may include the light source module in any one of the foregoing embodiments. In other words, the light source module provided in embodiments of this application may be used for all optical display devices that need to control temperature stability of a light source in a light source module.

For example, the optical display device may include but is not limited to an in-vehicle display, an HUD, a NED device, a projector, and a smart home device (for example, a smart desk lamp, a sound system, a smart lighting system, an electrical appliance control system, home background music, a home theater system, an intercom system, or video surveillance).

In embodiments of this application, unless otherwise stated or there is a logic conflict, terms and/or descriptions between different embodiments are consistent and may be mutually referenced, and technical features in different embodiments may be combined into a new embodiment based on an internal logical relationship thereof.

In this application, "even" does not mean being absolute even, and an engineering error may be allowed. "Perpendicular" does not mean being absolute perpendicular, and an engineering error may be allowed. "Higher" does not mean being absolute higher, and an engineering error may be allowed. "At least one" means one or more, and "a plurality of" means two or more. The term "and/or" describes an association relationship between associated objects and represents that three relationships may exist. For example, A and/or B may indicate the following cases: A exists alone, both A and B exist, and B exists alone, where A and B may be singular or plural. "At least one of the following items (pieces)" or a similar expression thereof indicates any combination of these items, including a single item (piece) or any combination of a plurality of items (pieces). For example, at least one of a, b, or c may indicate a, b, c, "a and b", "a and c", "b and c", or "a, b, and c", where a, b, and c may be singular or plural. In the descriptions of this application, the character "/" usually indicates an "or" relationship between associated objects. In a formula of this application, the character "/" usually indicates a "division" relationship between associated objects. In addition, in this application, the word "example" is used to give an example, an illustration, or a description. Any embodiment or design scheme described as an "example" in this application should not be explained as being more preferred or having more advantages than another embodiment or design scheme. Alternatively, it may be understood that the word "example" is intended to present a concept in a specific manner, and does not constitute a limitation on this application.

It may be understood that various numbers in this application are merely used for differentiation for ease of description, and are not intended to limit the scope of the embodiments of this application. It should be understood that sequence numbers of the foregoing processes do not mean execution sequences. The execution sequences of the processes should be determined based on functions and internal logic of the processes. The terms "first", "second", and the like are intended to distinguish between similar objects but do not indicate a particular order or a sequence. In addition, the terms "include", "have", and any variant thereof are intended to cover non-exclusive inclusion, for example, include a series of steps or units. A method, system, product, or device that includes a list of steps or units is not necessarily limited to those expressly listed steps and units, but may include other steps or units not expressly listed or inherent to such a process, method, product, or device.

Although this application is described with reference to specific features and embodiments thereof, it is clear that various modifications and combinations may be made without departing from the spirit and scope of this application. Correspondingly, the specification and accompanying drawings are merely examples for description of the solutions defined by the appended claims, and are considered as any of or all modifications, variations, combinations or equivalents that cover the scope of this application.

It is clear that a person skilled in the art can make various modifications and variations to this application without departing from the spirit and scope of the present invention. This application is intended to cover these modifications and variations in embodiments of this application provided that they fall within the scope defined by the following claims and their equivalent technologies.

## Claims

1. A light source module, comprising:
a light source component configured to transmit an optical signal;
a cooling component stacked with the light source component; and
a storage structure, wherein the storage structure comprises at least one first side wall, and the at least one first side wall contains at least a part of the cooling component.

2. The light source module according to claim 1, wherein the storage structure further comprises a bottom plate, and the bottom plate is in contact with a first end of the first side wall.

3. The light source module according to claim 2, wherein a thermal conductivity of a material of the bottom plate is higher than a thermal conductivity of a material of the first side wall.

4. The light source module according to claim 2 or 3, wherein the material of the first side wall is a heat insulation material, and/or the material of the bottom plate is a heat conduction material.

5. The light source module according to any one of claims 1 to 4, wherein a second end of the first side wall is connected to the light source component by using a structural adhesive, and the second end of the first side wall is opposite to the first end of the first side wall.

6. The light source module according to any one of claims 2 to 5, wherein the storage structure further comprises at least one second side wall, and the at least one second side wall contains at least a part of the first side wall.

7. The light source module according to claim 6, wherein the at least one second side wall further contains at least a part of the light source component.

8. The light source module according to claim 6 or 7, wherein the bottom plate and the second side wall are integrally formed.

9. The light source module according to any one of claims 6 to 8, wherein the second side wall is higher than the first side wall.

10. The light source module according to any one of claims 1 to 9, wherein the first side wall is of a "strip" type or an "L" type.

11. The light source module according to any one of claims 2 to 10, wherein the light source module further comprises a shielding cover, and the shielding cover is electrically connected to the bottom plate or the second side wall.

12. The light source module according to any one of claims 2 to 11, wherein a thermally conductive adhesive is filled between the bottom plate and a support component, and the support component is configured to support the light source module; and/or
a thermally conductive adhesive is filled between the bottom plate and the cooling component.

13. The light source module according to any one of claims 2 to 11, wherein the bottom plate comprises an opening; and
the cooling component passes through the opening and is in contact with the support component.

14. The light source module according to claim 13, wherein a structural adhesive is filled between a non-opening area of the bottom plate and the support component; and/or
a thermally conductive adhesive is filled between the cooling component and the support component.

15. The light source module according to any one of claims 1 to 14, wherein the light source component comprises a light source and a substrate; and
the substrate is configured to drive the light source to transmit the optical signal.

16. The light source module according to claim 15, wherein a difference between any two of a coefficient of thermal expansion of the substrate, a coefficient of thermal expansion of the second side wall, and a coefficient of thermal expansion of the first side wall is less than a first threshold.

17. The light source module according to claim 15 or 16, wherein the light source comprises a laser diode.

18. The light source module according to any one of claims 1 to 17, wherein the material of the first side wall comprises any one or a combination of two of the following:
glass or acrylic.

19. A detection device, comprising the light source module according to any one of claims 1 to 18.

20. The detection device according to claim 19, wherein the detection device further comprises a receiving module; and
the receiving module is configured to receive an echo signal corresponding to an optical signal, wherein the echo signal is used to obtain association information of a target detected by the detection device.

21. The detection device according to claim 19 or 20, wherein the detection device is a lidar device.

22. The detection device according to claim 19 or 20, wherein the detection device further comprises an image obtaining module; and
the image obtaining module is configured to obtain image information.

23. The detection device according to claim 22, wherein the detection device is a fusion sensor.

24. A terminal device, comprising the detection device according to any one of claims 19 to 23 and a processor, wherein
the processor is configured to plan a driving route based on association information of a target and/or image information.
